# EUROPÄISCHE PATENTANMELDUNG

(11) **EP 1 916 353 A2**
(43) Veröffentlichungstag der Anmeldung: **30.04.2008**
(21) Anmeldenummer: 07020861.6
(22) Anmeldetag: 24.10.2007
(51) Int. Cl.: E04D 13/03, F24J 2/52, H01L 31/048, H01L 31/05

(54) **Lichtband**

(30) Priorität: 26.10.2006 DE 202006016709 U
(71) Anmelder: Essmann GmbH, 32107 Bad Salzuflen (DE)
(72) Erfinder: Koch, Ulrich Dr., 32107 Bad Salzuflen (DE)
(74) Vertreter: von Bülow, Tam

(57) **Zusammenfassung**

Lichtband mit einer Rahmenkonstruktion (2, 3, 5) an der ein oder mehrere Flächenelemente (10) festgelegt sind. An der Rahmenkonstruktion (2, 3, 5) sind Montageelemente (6) gehalten, an denen ein oder mehrere Solarelemente (8) fixiert sind (Fig. 1).

## Beschreibung

Die vorliegende Erfindung betrifft ein Lichtband, insbesondere für Dächer.

Aus der EP 1 452 661 ist ein Lichtband mit einem Beschattungssystem bekannt, wobei das Lichtband eine Rahmenkonstruktion aufweist, an der insbesondere transparente oder transluzente Flächenelemente festgelegt sind. Oberhalb des Lichtbandes sind Längsstreben montiert, an denen eine mit Aussparungen versehene Platte als Beschattungselement montiert ist. Dadurch kann die Intensität des Lichteinfalles reduziert werden. Durch das Beschatten wird allerdings die auftreffende Lichtenergie in keiner Weise genutzt.

Ferner sind Solarelemente bekannt, die an Montagelementen festgelegt sind, die an Dächern montiert werden. Hierbei ist es aufwendig, die Montagelemente separat am Dach festzulegen und somit die Solarelemente zu fixieren.

Es ist daher Aufgabe der vorliegenden Erfindung ein Lichtband zu schaffen, bei dem die auftreffende Lichtenergie zumindest teilweise genutzt werden kann.

Diese Aufgabe wird mit einem Lichtband mit den Merkmalen des Anspruches 1 gelöst.

Erfindungsgemäß umfasst das Lichtband seine Rahmenkonstruktion, an der ein oder mehrere Flächenelemente festgelegt sind, wobei an der Rahmenkonstruktion Montageelemente gehalten sind, an denen ein oder mehrere Solarelemente fixiert sind. Dadurch kann die Konstruktion des Lichtbandes einerseits als Lichteinlass für eine Gebäudeöffnung genutzt werden und andererseits können die Solarelemente die auftreffende Lichtenergie nutzen, insbesondere zur Stromerzeugung. Hierfür können entsprechende Photovoltaik Elemente eingesetzt werden. Auch andere Solarelemente können am Lichtband montiert werden. Dadurch können die Solarelemente die Rahmenkonstruktion des Lichtbandes nutzen und die Montage kann vergleichsweise einfach durchgeführt werden. Zudem bieten die Solarelemente gleichzeitig auch eine gewisse Verschattung, so dass auf zusätzliche Verschattungselemente verzichtet werden kann.

Gemäß einer bevorzugten Ausgestaltung der Erfindung sind die Solarelemente plattenförmig oberhalb der Flächenelemente des Lichtbandes angeordnet. Dadurch kann das Lichtband die Solarelemente als zusätzliches Bauteil aufweisen, auf das optional auch verzichtet werden kann. Es ist natürlich auch möglich, die Solarelemente innerhalb der Rahmenkonstruktion des Lichtbandes festzulegen.

Vorzugsweise sind die Solarelemente über Schienen festgelegt, die an denen mit der Rahmenkonstruktion verbundenen Montageelementen gehalten sind. Dadurch können auch mehrere Solarelemente nebeneinander über eine größere Länge effektiv montiert werden.

Um die Sonneneinstrahlung möglichst gut auszunutzen, können die Solarelemente verschwenkbar angeordnet sein.

Um mit dem Lichtband gleichzeitig auch eine Belüftung durchführen zu können, können die Flächenelemente zumindest teilweise geöffnet und geschlossen werden.

Für eine stabile Rahmenkonstruktion ist diese in einem vertikalen Querschnitt im Wesentlichen dreiecksförmig ausgebildet. Dabei können die Montageelemente mit der Rahmenkonstruktion verschraubt sein, um eine dauerhafte Verbindung zu gewährleisten.

Gemäß einer weiteren Ausgestaltung der Erfindung kann am Lichtband eine Wärmepumpe zur Verwertung der anfallenden Wärme vorgesehen sein. Über die Wärmepumpe kann beispielsweise Brauchwasser erhitzt werden oder eine Anlage zur Gebäudekühlung betrieben werden. Dadurch kann der Einsatzbereich des Lichtbandes erweitert werden.

Die Erfindung wird nachfolgend anhand eines Ausführungsbeispieles mit Bezug auf die beigefügten Zeichnungen näher erläutert. Es zeigen:

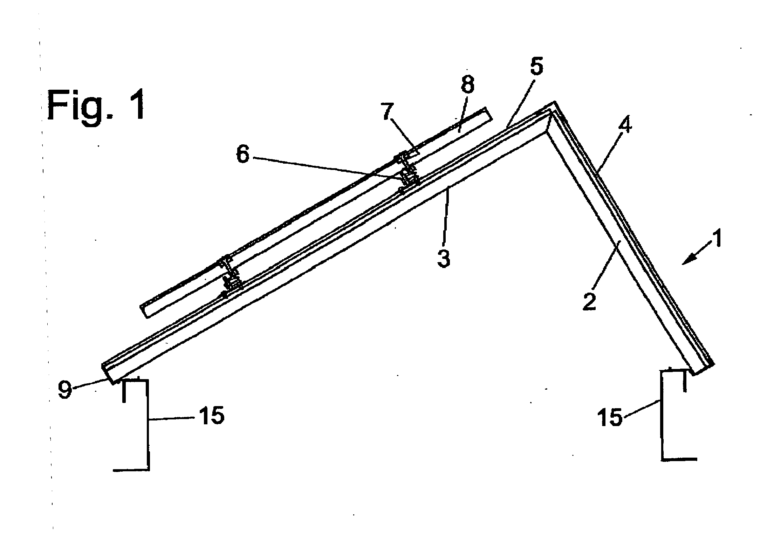

- Figur 1: eine Schnittansicht durch ein Ausführungsbeispiel eines erfindungsgemäßen Lichtbandes;
- Figur 2: eine Draufsicht auf das Lichtband der Figur 1;
- Figuren 3 bis 7: verschiedene Modifikationen des Lichtbandes der Figur 1.

Ein Lichtband 1 umfasst eine Rahmenkonstruktion 2 und 3 aus Profilen, die über Befestigungselemente aneinandergehalten sind und an denen Flächenelemente 10 festgelegt sind, die zwischen den Profilen 2 und 3 und Leisten und 5 montiert sind. Die Flächenelemente 10 können als ganz oder teilweise lichtdurchlässige Glaselemente oder Kunststoffelemente ausgebildet sein. An der Rahmenkonstruktion 2 und 3 sowie den Leisten 4 und 5 sind an bestimmten Positionen Montagelemente 6 über Schrauben montiert, die als Schienen ausgebildet sein können und über Befestigungsmittel 7 Solarelemente 8 fixieren. Die Solarelemente 8 können plattenförmig ausgebildet sein und seitlich klemmend festgelegt werden. Die Solarelemente 8 sind dabei beabstandet von einem Flächenelement 10 angeordnet, so dass die Solarelemente 8 als Aufbau montiert sind.

Die Rahmenkonstruktion 2 und 3 umfasst an den randseitigen Enden Abschlussprofile 9, wobei benachbart zu den Abschlussprofilen 9 die Profile 2 und 3 an einer Zarge 15 befestigt sind.

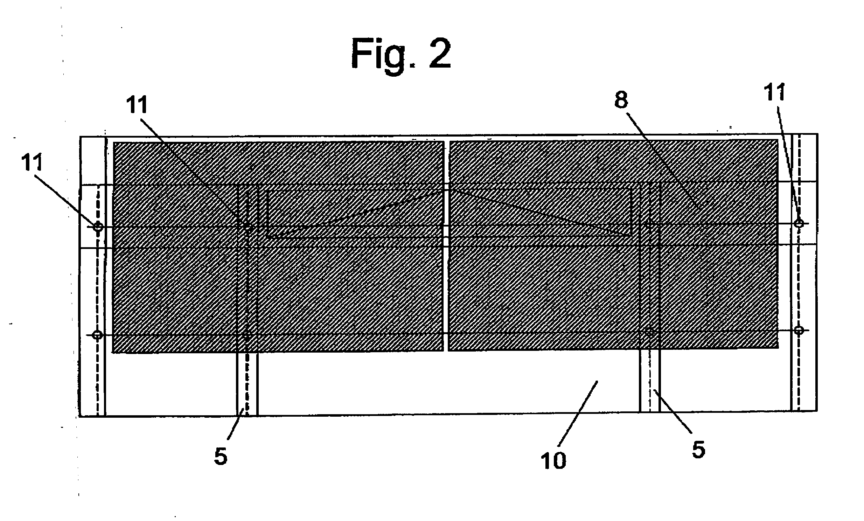

Wie in Figur 2 zu sehen ist, sind die Solarelemente 8 im Wesentlichen rechteckig ausgebildet und an mehreren Befestigungspunkten 11 an der Rahmenkonstruktion an den Leisten 5 festgelegt. Die Länge und Breite der Solarelemente 8 kann abhängig von der Größe des Lichtbandes 1 gewählt sein, wobei durch die Montage an der Rahmenkonstruktion und den Leisten 5 eine flexible Gestaltung möglich ist.

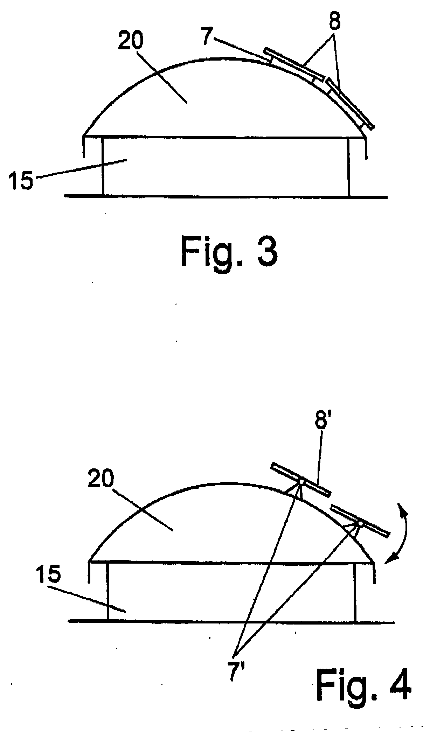

In den Figuren 3 bis 7 sind modifizierte Ausgestaltungen von Lichtbändern gezeigt.

Bei dem in Figur 3 dargestellten Lichtband ist eine Kuppel 20 ausgebildet, an der über Befestigungselemente 7 Solarelemente 8 festgelegt sind, die aufgrund der Krümmung der Kuppel 20 winklig zueinander angeordnet sind.

Bei dem in Figur 4 gezeigten Ausführungsbeispiel für ein Lichtband 20 sind ebenfalls Solarelemente 8' montiert, wobei ein Befestigungselement 7' mit der Rahmenkonstruktion verbunden ist und eine schwenkbare Lagerung der Solarelemente 8' ermöglicht. Dadurch können die Solarelemente 8' an den Einfallswinkel der Sonne angepasst werden.

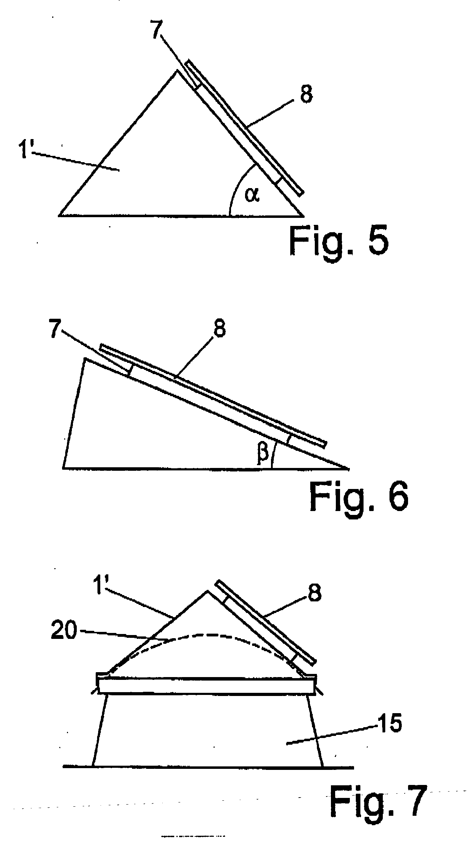

In Figur 5 ist ein Lichtband 1' gezeigt, bei dem die Solarelemente 8 über Befestigungselemente 7 an einer Rahmenkonstruktion gehalten sind, wobei die Rahmenkonstruktion des Lichtbandes in einem vertikalen Querschnitt im Wesentlichen dreiecksförmig ausgebildet ist, wobei der Neigungswinkel α an den gegenüberliegenden Seite etwa gleich groß ist.

Bei dem in Figur 6 gezeigten Ausführungsbeispiel ist das Lichtband so ausgebildet, dass in einem vertikalen Querschnitt ein dreiecksförmiger Aufbau der Rahmenkonstruktion gegeben ist, allerdings der Neigungswinkel β geringer ist als bei dem vorangegangenen Ausführungsbeispiel der Figur 5.

In Figur 7 ist eine weitere Modifikation eines Lichtbandes 1' gezeigt, bei dem eine im vertikalen Querschnitt dreiecksförmige Rahmenkonstruktion oberhalb einer gebogenen Lichtkuppel 20 vorgesehen ist. Die Kuppel 20 ist an einer Zarge 15 wie bei den vorangegangenen Ausführungsbeispielen montiert. An dem Lichtband können lüftungstechnische Anlagen, insbesondere Öffner zum Öffnen und Schließen von Flächenelementen vorgesehen sein, so dass das Lichtband eine weitere Funktionalität besitzt. Zudem können auch Wärmepumpen installiert sein, die den im Bereich des Lichtbandes anfallende Wärme zur Erhitzung von Brauchwasser oder anderen Anlagen nutzt. Weiter kann die anfallende Wärme bei Verwendung entsprechender Anlagen zur Gebäudekühlung eingesetzt werden.

## Patentansprüche

1. Lichtband (1), insbesondere für Dächer, mit einer Rahmenkonstruktion (2, 3, 5), an der ein oder mehrere Flächenelemente (10) festgelegt sind, wobei an der Rahmenkonstruktion (2, 3, 5) Montageelemente (6) gehalten sind, an denen ein oder mehrere Solarelemente (8) fixiert sind.

2. Lichtband nach Anspruch 1, **dadurch gekennzeichnet, dass** die Solarelemente (8) plattenförmig oberhalb der Flächenelemente (10) des Lichtbandes angeordnet sind.

3. Lichtband nach Anspruch 1 oder 2, **dadurch gekennzeichnet, dass** die Solarelemente (8) über Schienen (6) festgelegt sind, die an den auf der Rahmenkonstruktion (2, 3, 5) angeordneten Montageelementen gehalten sind.

4. Lichtband nach einem der Ansprüche 1 bis 3, **dadurch gekennzeichnet, dass** die Solarelemente (8) verschwenkbar angeordnet sind.

5. Lichtband nach einem der Ansprüche 1 bis 4, **dadurch gekennzeichnet, dass** die Flächenelemente (10) zumindest teilweise geöffnet und geschlossen werden können.

6. Lichtband nach einem der Ansprüche 1 bis 5, **dadurch gekennzeichnet, dass die Rahmenkonstruktion (2, 3, 5) in einem vertikalen Querschnitt im** Wesentlichen dreiecksförmig ausgebildet ist.

7. Lichtband nach einem der Ansprüche 1 bis 6, **dadurch gekennzeichnet, dass** die Montageelemente (6) mit der Rahmenkonstruktion (2, 3, 5) verschraubt sind.

8. Lichtband nach einem der Ansprüche 1 bis 7, **dadurch gekennzeichnet, dass** am Lichtband (1) eine Wärmepumpe zur Verwertung der anfallenden Wärme vorgesehen ist.
